# EUROPÄISCHE PATENTSCHRIFT

(11) **EP 3 667 917 B1**
(45) Veröffentlichungstag und Bekanntmachung des Hinweises auf die Patenterteilung: **30.09.2026**
(21) Anmeldenummer: 19000558.7
(22) Anmeldetag: 13.12.2019
(51) Int. Cl.: H03K 17/30, H02M 7/5383

(54) **STEUERSCHALTUNG FÜR EINE OSZILLATORSCHALTUNG ZUM BETRIEB VON PARALLELGESPEISTEN OSZILLATOREN**
CONTROL CIRCUIT FOR AN OSCILLATOR CIRCUIT FOR OPERATING PARALLEL-FED OSCILLATORS
CIRCUIT DE COMMANDE POUR UN CIRCUIT OSCILLATEUR DESTINÉ AU FONCTIONNEMENT DES OSCILLATEURS À ALIMENTATION PARALLÈLE

(30) Priorität: 14.12.2018 DE 102018132214
(43) Veröffentlichungstag der Anmeldung: 17.06.2020
(73) Patentinhaber: Technische Hochschule Mittelhessen, Körperschaft des öffentlichen Rechts, 35390 Giessen (DE)
(72) Erfinder: Reeh, Andreas, 35396 Gießen (DE)
(74) Vertreter: Stumpf, Peter

(56) Entgegenhaltungen:
- DE-A1- 102007 009 428
- DE-T5- 112012 001 842
- US-A- 5 818 084
- US-A1- 2007 200 006
- US-A1- 2012 268 222
- JÖRG REHMANN: "Oszillatoren", 5 January 2011 (2011-01-05), Internet, XP055683095, Retrieved from the Internet <URL:https://web.archive.org/web/20110105084148/http://www.joretronik.de/Oszillatoren/Oszillatoren.html> [retrieved on 20200406]
- ANONYMOUS: "Diode-connected transistor - Wikipedia", 4 March 2018 (2018-03-04), XP093034200, Retrieved from the Internet <URL:https://en.wikipedia.org/w/index.php?title=Diode-connected_transistor&oldid=828667878> [retrieved on 20230323]

## Beschreibung

Die vorliegende Erfindung betrifft eine verbesserte Steuerschaltung für eine Oszillatorschaltung zum Betrieb von parallelgespeisten Oszillatoren.

### Beschreibung und Einleitung des allgemeinen Gebietes der Erfindung

Oszillatoren werden in der Elektrotechnik eingesetzt, um aus Gleichspannung ein Wechselsignal zu erzeugen. Das Ausgangssignal des Oszillators kann, je nach Anforderung, verschiedene Verlaufsformen haben. Oszillatorschaltungen arbeiten mit aktiven Bauelementen. Diese sind in der Elektrotechnik normalerweise Transistoren. Damit das System anschwingt und am Schwingen bleibt, muss dem Schwingkreis phasenrichtig Leistung zugeführt werden. Um diese phasenrichtige Anregung zu ermöglichen, wird zur Ansteuerung der aktiven Bauelemente das Ausgangssignal bzw. dessen Phaseninformation verwendet. Bei analogen Oszillatorschaltungen kann dies über phasenverschobene Rückführung des Ausgangs eines Transistors auf dessen Eingang geschehen. Zur Anpassung der hohen Ströme/Spannungen des Ausgangs auf die geringeren Ströme/Spannungen am Eingang wird oftmals ein aktives oder passives Rückführnetzwerk vorgesehen.

Je nach Verwendungszweck ergeben sich verschiedene Anforderungen.

Ein erstes Anwendungsgebiet ist der Einsatz in der Nachrichtentechnik:
Typische Oszillatorschaltungen sind hier Colpitts-Schaltung, RC-Sinusoszillator oder Meißner-Oszillator.

Diese Schaltungen bestehen aus einem Transistor, dessen Ausgangssignal phasenverschoben auf den Eingang zurückgeführt wird.

Jene Oszillatoren dienen als Signalgeneratoren zur Erzeugung von Hochfrequenzsignalen mit Frequenzen bis zu mehreren 100 MHz. Bei diesen Schaltungen arbeiten die Transistoren analog bzw. im linearen Betrieb. Das Eingangssignal der Transistoren ist sinusförmig.

Die wichtigsten Kriterien in diesem Anwendungsgebiet sind die Stabilität von Amplitude, Frequenz und Phase.

Bei der Konzeptionierung dieser Schaltungen erfolgt eine Arbeitspunkteinstellung gemäß dem Großsignalverhalten und anschließend wird im Kleinsignal-Ersatzschaltbild linearisiert. Die benötigten Ausgangsspannungen sind eher klein. Die Ausgangsleistungen liegen für gewöhnlich im Bereich bis zu wenigen Watt (bis 10 W) bei Ausgangsspannungen bis zu wenigen Volt (bis zu 24V).

Ein zweites Anwendungsgebiet ist der Einsatz in der Leistungselektronik:
Hierbei werden Oszillatoren als Resonanzwandler z.B. in DC-DC-Wandlern oder beim Anregen von LC-Schwingkreisen für Induktionsöfen oder Plasmen eingesetzt.

Je nach Leistungsbereich werden verschiedene elektrische Schalter bevorzugt eingesetzt. In der Reihenfolge von kleinen Leistungen (unter 10 W) bis zu großen Leistungen (größer 10 kW) werden Bipolartransistoren, MOSFETs oder IGBTs eingesetzt. Hierbei steht MOSFET für metal-oxide-semiconductor field-effect transistor bzw. übersetzt Metall-Oxid-Halbleiter-Feldeffekttransistor und IGBT für insulatedgate bipolar transistor bzw. übersetzt Bipolartransistor mit isolierter Gate-Elektrode. Die angegebenen Leistungen dienen als Richtwert und die Bereiche ab wann welche Schalter eingesetzt werden überlappen. Im Rahmen der Patentanmeldung kommen MOSFETs und IGBTs zum Einsatz. MOSFETs für Leistungsanwendungen verfügen typischerweise über die drei Anschlüsse:
- Source
- Gate (Dieser Anschluss dient als Steuerelektrode)
- Drain

Im Folgenden werden spannungsgesteuerte Leistungsschalter verwendet. Für diese wird einfachheitshalber das Schaltsymbol und die Pinbezeichnung eines MOSFETs verwendet, auch wenn dies z.B. ein IGBT sein könnte.

Ein wichtiges Kriterium in diesem Anwendungsgebiet als Leistungsoszillator ist der Wirkungsgrad. Deshalb werden meist Methoden zur Minimierung der Schaltverluste angewandt.

Gängige Verfahren sind Zero-Voltage-Switching (ZVS) oder Zero-Current-Switching (ZCS).

Da während des Schaltvorgangs erhöhte Verluste in den Leistungsschaltern entstehen, wird der Wirkungsgrad zusätzlich durch möglichst geringe Schaltzeiten verbessert. Dies wird durch ein digitales Arbeiten der Schalter erreicht. Diese sind also entweder ein- oder ausgeschaltet. Hierzu werden annähernd rechteckförmige Eingangssignale an den Gates benötigt. Ein solches Signal ist mit einer passiven Rückführung des Ausgangssignals (sinusförmig) auf den Eingang für gewöhnlich nicht erreichbar. Deswegen werden zusätzliche aktive Elemente wie z.B. Gate-Treiber benötigt, um die Gates schnell umzuschalten/umzuladen.

Diese aktiven Bauelemente sind auf ein digitales Schalten ausgelegt. Beim Unter- bzw. Überschreiten einer bestimmen Eingangsspannung wird der Ausgang des Treiberbausteins "sprunghaft" umgeschaltet. Diese Gate-Treiber haben jedoch eine Verzögerung (delay) von mehreren ns. Als Gate-Treiber (MOSFET-Treiber, IGBT-Treiber oder Halbbrücken-Treiber) bezeichnet man in der Elektronik, speziell der Leistungselektronik, eine diskrete oder integrierte elektronische Schaltung, welche Leistungsschalter, wie beispielsweise MOSFETs oder IGBTs, ansteuert.

Ferner kann ein einfacher Gate-Treiber als eine Kombination aus Pegelumsetzer und Verstärker (Impedanzwandler) gesehen werden.

Der Einsatz dieser Gate-Treiber ermöglicht geringe Schaltzeiten, erschwert jedoch die oben genannten Verfahren ZVS und ZCS, da das Schalten nun verzögert durchgeführt wird und dadurch u. U. nicht mehr im Strom- bzw. Spannungsnulldurchgang erfolgt. Diese Problematik tritt besonders bei Leistungsanwendungen im Frequenzbereich von mehreren MHz auf.

### Stand der Technik

Eine Topologie für einen Parallelschwingkreis die auch für Leistungsanwendungen verwendet wird, ist der Royer Converter. Genau genommen ist dies ein Gegentakt-Rechteckgenerator. Dieser ist beispielsweise in der Schrift US2783384 dargestellt.

Diese Variante arbeitet mit einem Transformator, der in Sättigung betrieben wird, mit zwei Bipolartransistoren und entsprechenden Transformatorabgriffen zur Ansteuerung der Schalter. Das Ausgangssignal ist rechteckförmig.

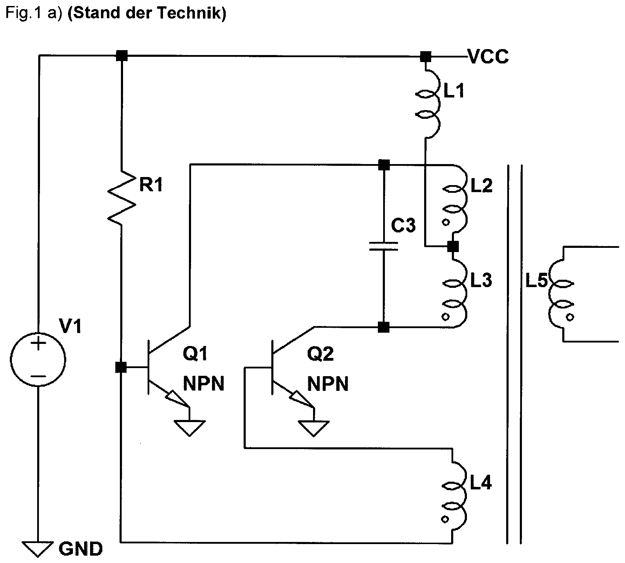

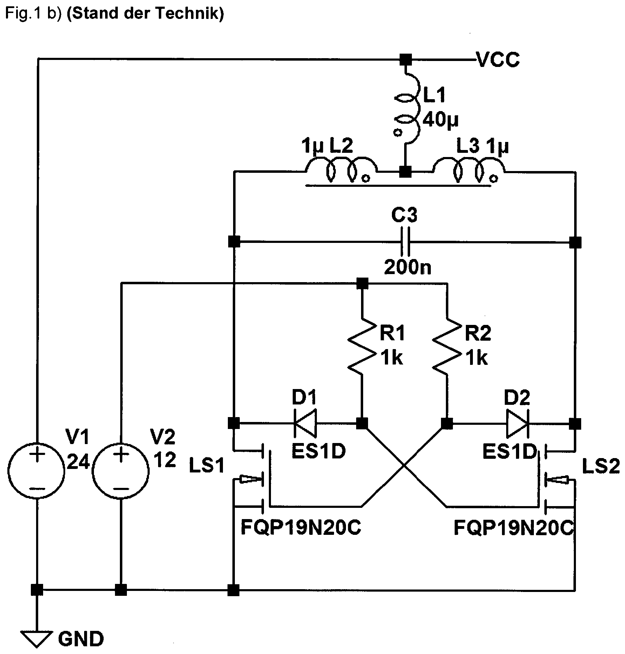

Parallelgespeiste Gegentakt-Oszillatorschaltungen (Royer-Oszillator) (siehe Abbildung Fig.1 a) werden schon seit längerer Zeit, insbesondere als Inverter zur Hochspannungserzeugung für CCFL-Röhren, z. B. in LCD-Hintergrundbeleuchtungen eingesetzt und zeichnen sich durch besonders einfache Bauweise und hohen Wirkungsgrad aus. Außerdem treten keine steilflankigen Spannungen auf, was sich günstig auf die elektromagnetische Verträglichkeit (EMV) auswirkt. Bei diesen Anwendungen werden parallelgespeiste Gegentakt-Oszillatorschaltungen mit Leistungen unter 20 Watt eingesetzt. Diese sind mit zwei NPN-Transistoren aufgebaut, die über eine Rückkopplungswicklung im LC-Resonanzkreis zum Schwingen angeregt werden.

Bekannt sind auch MOSFET-Schaltungen mit Rückkopplung über den Lastkreis durch eine Diodenkopplung mit Pullup-Widerständen (siehe Abbildung Fig.1 b). Hierbei entfällt die Rückkopplungswicklung, die zur Ansteuerung benötigt wird. Zudem sind höhere Frequenzen und Leistungen möglich. Diese Schaltungen haben jedoch den Nachteil, dass man sich in der Auslegung zwischen hohen Verlusten in den Pullup-Widerständen und langsamen Schaltzeiten der MOSFETs entscheiden muss. Zudem kann gerade bei dem Einsatz über einen großen Leistungsstellbereich eine Hilfsspannung notwendig werden.

Bei Leistungsanwendungen übersteigt die vorliegende Ausgangsspannung (einige 100 V) die Eingangsspannungsfestigkeit der Transistoren (bei Silizium-Mosfets typischerweise 20 V) bei weitem. Ein Rückführungsnetzwerk ist also zwingend erforderlich.

Übliche Verfahren die bei dem Rückführungsnetzwerk Anwendung finden:
1. Pegelreduktion durch lineare Bauteile (Spannungs- oder Stromteiler)
2. Begrenzung der Eingangsspannung (z. B. durch Z-Dioden)
3. Verwendung einer Hilfsspannung, die auf die erlaubten Spannungspegel am Eingang ausgelegt wird
4. Verwendung weiterer aktiver Bauelemente wie z. B. Gate-Treiber

Bei Verwendung der Verfahren 1 bis 3 ergeben sich diverse Nachteile:
- Bei einem Rückführungsnetzwerk, besonders wenn kein schaltendes Element verwendet wird, muss bei der Wahl der Rückkopplungsimpedanz ein Kompromiss aus Schaltverlusten und Ansteuerverlusten gefunden werden.
- Bei einer Rückführung durch lineare Bauteile bleibt die Form des Ausgangssignals erhalten. Bei einem sinusförmigen Ausgangssignal können die Transistoren nicht rechteckförmig angesteuert werden.
- Wird die Eingangsspannung begrenzt, wie z. B. durch eine Z-Diode, erzeugt die Abfuhr des überflüssigen Stroms Verluste.
- Bei Verfahren 3 werden zusätzliche Bauteile benötigt.

Aufgrund der erhöhten Schaltverluste bei diesen Verfahren wird bei mittleren bis hohen Leistungen meist Variante 4 verwendet. Das Ausgangssignal wird digitalisiert auf Basis eines Merkmals wie z.B. Stromnulldurchgang. Dieses Signal wird analog oder digital ausgewertet und dient im Rahmen einer entsprechenden Regelung zur Ansteuerung von Gate-Treibern. Der technische Mehraufwand wird bei hohen Leistungen durch den verbesserten Wirkungsgrad (Verlustreduktion in den Leistungsschaltern) gerechtfertigt.

Nachteile dieser Variante sind:
- Insbesondere bei hohen Ausgangsfrequenzen liegt die Totzeit von Gate-Treibern in dem Bereich der Periodendauer des angestrebten Ausgangssignals. Aufgrund der Verzögerung kann es zu nicht optimalen Schaltzeitpunkten kommen und die Schaltverluste sind erhöht.
- Es wird meist mindestens eine Hilfsspannung mit entsprechendem zusätzlichen Leistungsbedarf benötigt.
- Aufwendige technische Realisierung der Steuerung bzw. Regelung ist notwendig.

Ein Anwendungsbeispiel für Leistungsanwendungen im Frequenzbereich von mehreren MHz ist z.B. das Radiofrequenzionentriebwerk bei dem ein Plasma induktiv geheizt wird. Bei den hierzu verwendeten Radiofrequenzgeneratoren wird aktuell ein Konzept mit Serienschwingkreis verwendet. Hierbei wird über eine Steuerelektronik eine Frequenz- und Phasenregelung realisiert. Dies geschieht entweder analog oder digital. Hierzu kann u. a. eine PLL (phase-locked loop) verwendet werden. Gegenüber diesem Konzept entstehen technische Nachteile die überwunden werden sollen.

Ein weiteres Beispiel einer bekannten Steuerschaltung für parallelgespeiste Oszillatoren ist aus DE 10 2007 009428 A1 bekannt.

Ein alternatives Ansteuerkonzept, dass ohne Hilfsspannung, ohne aufwendige Steuerung bzw. Regelung und ohne Gate-Treiber auskommt, aber trotzdem eine vergleichbare oder bessere Effizienz erreicht, ist wünschenswert.

### Aufgabe

Aufgabe der vorliegenden Erfindung ist es eine einfache und kosteneffiziente Steuerschaltung für eine Oszillatorschaltung mit einem optimierten Wirkungsgrad bereitzustellen.

### Lösung der Aufgabe

Die Aufgabe wird durch die Vorrichtung mit den Merkmalen des Hauptanspruchs gelöst. Vorteilhafte alternative Ausführungsformen der Erfindung sind in den Unteransprüchen beschrieben.

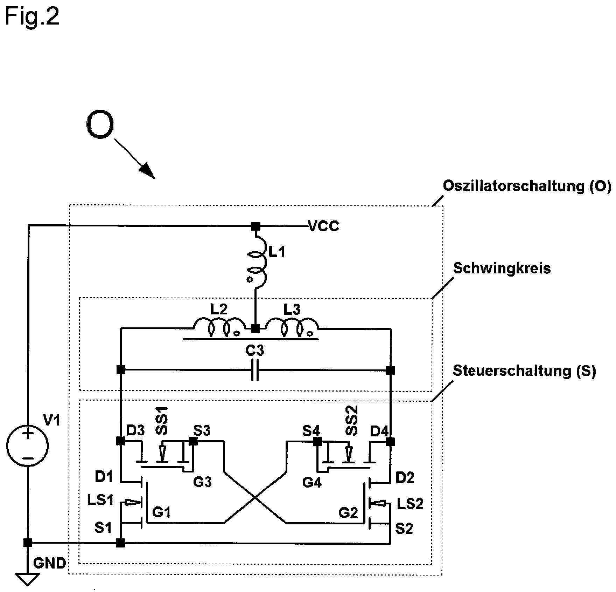

Die erfindungsgemäße Steuerschaltung S (siehe Fig. 2) für eine Oszillatorschaltung O zum Betrieb von parallelgespeiste Leistungsoszillatoren umfasst
- Einen ersten Leistungsschalter LS1 mit einer Source S1, einem Gate G1 und einem Drain D1
- Einen zweiten Leistungsschalter LS2 mit einer Source S2, einem Gate G2 und einem Drain D2
- Einen ersten Steuerschalter SS1 mit einer Source S3, einem Gate G3 und einem Drain D3
- Einen zweiten Steuerschalter SS2 mit einer Source S4, einem Gate G4 und einem Drain D4

Die Sources S1 und S2 der Leistungsschalter LS1 und LS2 sind gemeinsam mit Masse GND verbunden.

Die Steuerschalter SS1 und SS2 weisen jeweils eine Verbindung von den Gates (G3, G4) zu ihren eigenen Sources (S3, S4) auf. Dies bewirkt, dass beide Steuerschalter SS1 und SS2 geöffnet sind.

Die Steuerschalter SS1 und SS2 weisen damit nur die im Normalfall als parasitär betrachtete spannungsabhängige nicht-lineare Drain-Source-Kapazität C_{DS} sowie die Drain-Gate-Kapazität C_{DG} auf.

"Parasitär" bezeichnet hierbei eine Bauteileigenschaft die für die vom Hersteller vorgesehene Anwendung nicht vorhanden sein sollte und die ein ideales Bauteil nicht aufweisen würde. Bei einem solcherart "perfekten" Schalter gäbe es diese Kapazität C_{DS} nicht. Diese Kapazität ergibt sich zwangsläufig durch den internen Aufbau des realen Schalters.

Der Steuerschalter SS1 befindet sich in Reihe zwischen dem Drain D1 des Leistungsschalters LS1 und dem Gate G2 des Leistungsschalter LS2. Dabei weist der Drain D3 des Steuerschalters SS1 eine Verbindung mit dem Drain D1 des Leistungsschalters LS1 auf und die Source S3 des Steuerschalter SS1 weist eine Verbindung mit dem Gate G2 des Leistungsschalters LS2 auf.

Der Steuerschalter SS2 befindet sich in Reihe zwischen dem Drain D2 des Leistungsschalters LS2 und dem Gate G1 des Leistungsschalter LS1. Dabei weist der Drain D4 des Steuerschalters SS2 eine Verbindung mit dem Drain D2 des Leistungsschalters LS2 auf und die Source S4 des Steuerschalter SS2 weist eine Verbindung mit dem Gate G1 des Leistungsschalters LS1 auf.

Zusätzliche Elemente in der Reihenschaltung wie z. B. Widerstände sind möglich.

Für die Leistungsschalter LS1 und LS2 können Schalter mit den folgenden Eigenschaften verwendet werden:
- spannungsgesteuert
- N-Kanal Charakteristik (schließend mit steigender Gate-Source-Spannung)

Dies beinhaltet unter anderem MOSFETs die mit den Technologien Si, SiC und GaN gefertigt werden sowie IGBTs.

Bei dieser Art der Verschaltung wird ausgenutzt, dass das Ausgangssignal an D1 von Leistungsschalter LS1 phasenrichtig bzw. phasengleich mit dem benötigten Ansteuersignal des Gates G2 von Leistungsschalter LS2 ist, um ein schwingfähiges System zu erhalten. Aufgrund der Schaltungssymmetrie gilt gleiches für die Signalverläufe an D2 und G1. Um die Signalpegel des Ausgangssignals möglichst verlustarm auf die zum Ansteuern benötigten Pegel anzupassen, wird ein kapazitiver Spannungsteiler verwendet. Das zur Verfügung stehende Ausgangssignal an D1 bzw. D2 entspricht, bezogen auf Masse, einer sich wiederholenden positiven Sinushalbwelle. Während der halben Periodendauer, während der keine Sinushalbwelle anliegt, beträgt das Ausgangssignal annähernd 0 V. Um dieses "sinusähnliche" Ausgangssignal über einen großen Eingangsspannungsbereich in ein möglichst rechteckförmiges Eingangssignal zu wandeln ohne die maximal zulässige Gate-Source-Spannung der Leistungsschalter zu überschreiben, wird eine nicht-linearere Ausführung eines kapazitiven Spannungsteilers verwendet. Dieser besteht aus den genannten Kapazitäten Cos sowie C_{DG} der Steuerschalter und den Gatekapazitäten der Leistungsschalter LS1 und LS2.

Arbeitsverfahren der Steuerschaltung S am Beispiel LS1 und SS2:
- Solange die Gate-Source-Spannung des Leistungsschalter LS1 kleiner ist als die zum sicheren Durchschalten benötigte Spannung soll die Kapazität des SteuerMOSFET SS2 möglichst groß sein. Dies entspricht einem Kurzschluss zwischen dem Gate G1 des Leistungsschalters LS1 und des Drains D2 des Leistungsschalters LS2 (Ausgang der Schaltung). Hierdurch wird ein schnelles und niederimpedantes Laden- und Entladen der Gatekapazität des Leistungsschalter LS1 ermöglicht.
- Sobald die Gate-Source-Spannung des Leistungsschalter LS1 aufgrund des Aufladevorgangs eine Spannung größer gleich der zum sicheren Durchschalten benötigten Spannung erreicht hat, soll die Kapazität des SteuerMOSFET SS2 möglichst klein werden. Dies entspricht einem Auftrennen der Schaltung an dieser Stelle, sodass die Gatekapazität des Leistungsschalters LS1 nicht weiter geladen wird. Ein Defekt durch Überspannung wird vermieden.

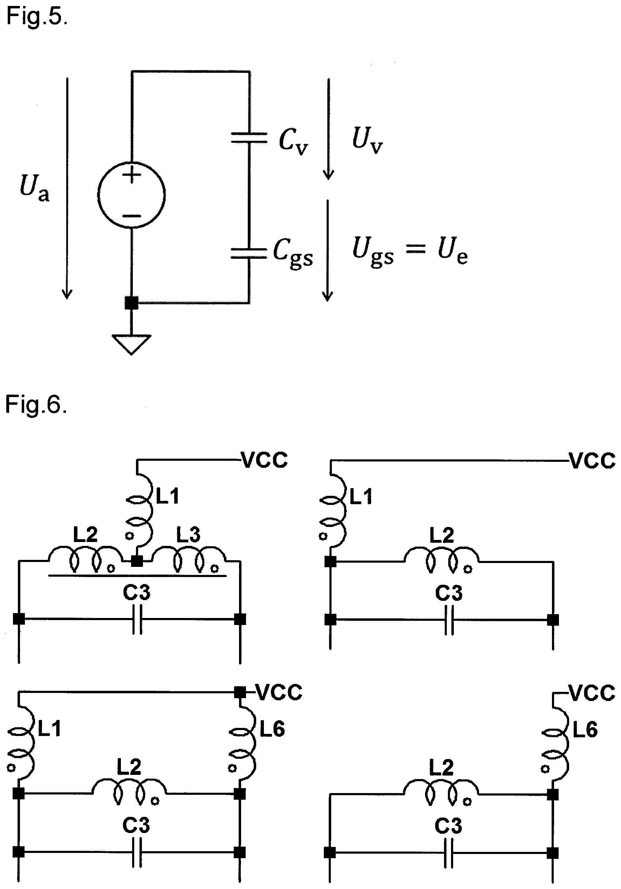

Bei einem nicht linearen kapazitiven Spannungsteiler (siehe Abbildung Fig.5), bestehend aus einer Vorkapazität Cᵥ und der Gatekapazität C_{gs} gilt: $\frac{d {U}_{gs}}{{dU}_{a}} = \frac{{C}_{{v}_{\left({U}_{v}\right)}}}{{C}_{{v}_{\left({U}_{v}\right)}} + {C}_{{gs}_{\left({U}_{gs}\right)}}}$

Hierbei ist Uₐ die Ausgangsspannung des Schwingkreises, die über beiden Kapazitäten anliegt. U_{gs} ist die Spannung an der Gatekapazität C_{gs} und Uv die Spannung an der Vorkapazität Cᵥ. Die Steigung kann $\frac{{dU}_{gs}}{{dU}_{a}}$ maximal 1 betragen, wenn Cᵥ unendlich groß ist und minimal 0, wenn Cv= 0.

Um die Ausgangsspannung in eine möglichst rechteckförmige Eingangsspannung zu überführen, ohne Überspannung an der Gatekapazität, gilt in idealer Weise:
a. Cᵥ >> C_{gs}, wenn U_{gs} kleiner der Gatespannung zum sicheren Durchschalten ist
b. Cᵥ << C_{gs}, wenn U_{gs} größer oder gleich der Gatespannung zum sicheren Durchschalten ist

Reale Bauteile können diese Bedingungen für den Verlauf ${C}_{{v}_{\left({U}_{v}\right)}}$ nicht streng erfüllen, da der Kapazitätsverlauf realer Bauteile stetig ist d.h. keine Sprünge aufweist. Zudem kommt hinzu, dass der Kapazitätswert von *C*ᵥ zwar von der Spannung *U*ᵥ aber nicht von der Spannung *U*_{gs} abhängt. Die Vorkapazität *C*ᵥ ist so zu wählen, dass der Kapazitätssprung dann einsetzt, wenn etwa die Ladung verschoben wurde, die an C_{gs} zu einer Gatespannung führt, die zum sicheren Durchschalten ausreichend ist. Nachdem das Gate auf die zum sicheren Durchschalten benötigte Spannung aufgeladen ist, kommt es zu einem weiteren Aufladen, da die Kapazität Cᵥ bei realen Bauteilen nicht bis auf 0 absinkt. Für die weitere Aufladung von *C*_{gs} gibt es einen Spannungspuffer bis zum Erreichen der maximal erlaubten Gatespannung.

Unter Zuhilfenahme der oben aufgeführten Auslegungskriterien kann eine systematische Abstimmung zwischen Vorkapazität und der Gatekapazität erfolgen. Zur Berechnung kann vorzugsweise ein Simulationstool verwendet werden.

Auf Halbleiterebene kann die Verlaufsform von ${C}_{{v}_{\left({U}_{v}\right)}}$ durch die Geometrie angepasst werden, wohingegen auf Bauteilebene eine Auswahl aus den begrenzt zur Verfügung stehenden Bauteiltypen getroffen werden muss.

Als besonders geeignet für die Vorkapazität erweisen sich aktuelle n-Kanal, normal sperrende LeistungsMOSFETs auf Siliziumbasis. Diese Typen weisen eine Cₒₛₛ-Kapazität (Summe auf C_{DS} und C_{DG}) auf, die typischerweise einen steilen Knick hat, so dass diese ab einer bestimmten Spannung sprungartig absinkt. Es sind Kapazitätssprünge größer als Faktor 100 möglich. Der Kapazitätssprung findet typischerweise bei Spannungen kleiner 20 V statt. Die Halbleitergeometrie (Produktionsserie) gibt die Verlaufsform von ${C}_{{v}_{\left({U}_{v}\right)}}$ vor. Der *R*_{DS₍ₒₙ₎} bestimmt die Anzahl der im Halbleiter parallel geschalteten Strukturen und erlaubt somit eine Wahl der Kapazitätshöhe.

Die spannungsabhängige parasitäre Kapazität ${C}_{{v}_{\left({U}_{v}\right)}}$ in der erfindungsgemäßen Steuerschaltung S weist die geforderten Eigenschaften a und b hinreichend gut auf, um als Vorkapazität Cᵥ zu dienen.

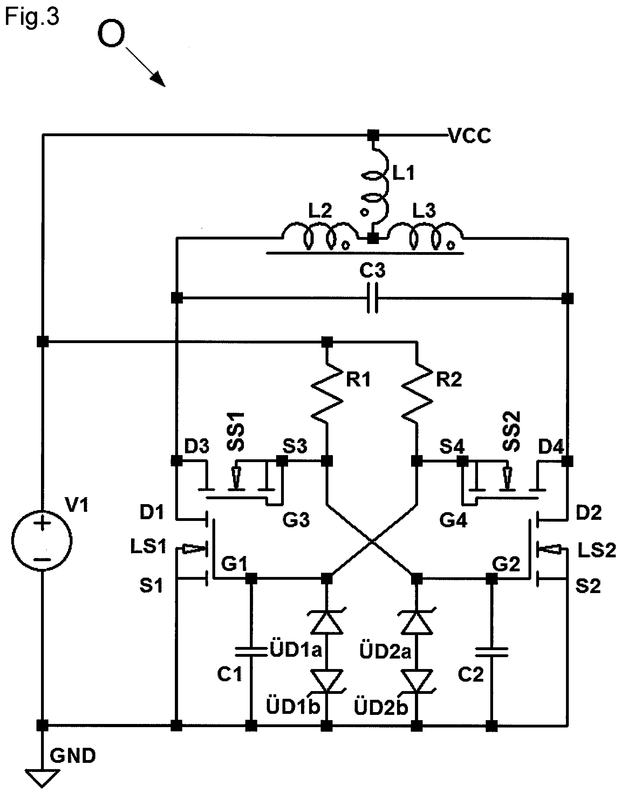

In einer weiteren Ausführungsform der erfindungsgemäßen Steuerschaltung S (siehe Fig. 3) befindet sich parallel zu den Gate-Source-Kapazitäten G1/S1 von Leistungsschalter LS1 und G2/S2 von LS2 noch eine externe Kapazität C1 und C2. Diese können verwendet werden, um die Spannung durch den nicht linearen kapazitiven Spannungsteiler weiter herunterzuteilen, und dadurch die Spannung am Gate anzupassen. Dies erlaubt eine kontinuierliche Anpassung des Spannungsteilerverhältnisses, während durch Bauteilwahl nur diskrete Verhältnisse möglich sind.

Die Schaltzeit sowie die Schaltverzögerung zwischen Spannungsnulldurchgang und Schaltzeitpunkt sinken mit der Thresholdspannung (Schwellspannung der Gate-Source-Strecke) der verwendeten Leistungsschalter LS1 und LS2. Dies liegt daran, dass die Gatespannung annähernd der Ausgangsspannung folgt.

Die maximal erlaubte Gatespannung sowie die Spannung, die zum sicheren Durchschalten benötigt wird, hängen von dem Typ des Leistungsschalters ab. Tabelle 1 zeigt eine Übersicht von typischen Werten:

**Tabelle 1: Typische Gatespannungen an den Leistungsschaltern**

| Typ des Leistungsschalters | SiC-Mosfet | Si-Mosfet | IGBT | Si-Mosfet logic level | GaN-Mosfet |
|---|---|---|---|---|---|
| Maximal erlaubte Gatespannung [V] | 25 | 20 bis 25 | 20 | 10 | 7 |
| Gatespannnung zum sicheren Durchschalten [V] | < 20 | < 12 | < 15 | < 5 | < 6 |

Die erfindungsgemäße Steuerschaltung S umfasst vorzugsweise weiterhin zwei Überspannungselemente ÜD1 und ÜD2 (siehe Fig. 3). Diese sind so ausgebildet, dass das Überspannungselement ÜD1 (dargestellt in Abbildung Fig.3 als ÜD1a und ÜD1b) die Gatespannung des Leistungsschalter LS1 begrenzt und das Überspannungselement ÜD2 (dargestellt in Abbildung Fig.3 als ÜD2a und ÜD2b) die Gatespannung der Leistungsschalter LS2 begrenzt. ÜD1 befindet sich zwischen den Anschlüssen S1 und G1 von LS1. ÜD2 befindet sich zwischen den Anschlüssen G2 und S2 von LS2. Die Gatespannung der Leistungsschalter LS1 und LS2 soll so hoch sein, dass ein sicheres Durchschalten (ohne hohe Verluste) des MOSFETs gewährleistet ist. Gleichzeitig darf sie die maximal zulässige Gate-Spannung der Leistungsschalter nicht überschreiten. Der Einsatz der Überspannungselemente erlaubt es, bei realen Vorkapazität schnellere Schaltzeiten zu realisieren, da größere Kapazitätswerte der Steuerschalter gewählt werden können, die sonst zu einer Überspannung an den Gatekapazitäten der Leistungsschalter LS1 und LS2 führen würden.

Die Überspannungselemente ÜD1 und ÜD2 können z.B. als TVS-Diode, als Z-Diode oder als antiseriell verschaltete Z-Dioden ausgeführt sein. Letztere besteht aus zwei Z-Dioden, deren Anoden verbunden sind. Dieses so entstehende Überspannungselement wird an seinen frei liegenden Kathoden angeschlossen. Dies ermöglicht es, auch negative Gatespannungen zuzulassen. Eine gezielte positive und negative Begrenzung der Gatespannungen ist somit möglich.

In einer weiteren Ausführungsform der erfindungsgemäßen Steuerschaltung S weist diese noch einen Vorwiderstand R1 zum zusätzlichen Laden der Gates G2 der Leistungsschalter LS2 auf. Dieser befindet sich zwischen einer Versorgungsspannung und dem Anschluss G2 von LS2. Weiterhin weist die erfindungsgemäßen Steuerschaltung S noch einen Vorwiderstand R2 zum zusätzlichen Laden der Gates G1 der Leistungsschalter LS1 auf. Dieser befindet sich zwischen einer Versorgungsspannung und dem Anschluss G1 von LS1 (siehe Fig. 3). Die Vorwiderstände R1 und R2 verbessern das Anschwingverhalten gerade bei kleinen Eingangsspannungen. Hierzu sind typischerweise Widerstandswerte größer gleich 100 kΩ ausreichend.

Aufgrund des kapazitiven Spannungsteilers liegt ohne Vorwiderstände beim Anschwingvorgang nicht die komplette Eingangsspannung an den Gatekapazitäten der Leistungsschalter LS1 und LS2 an. Gerade bei kleinen Eingangsspannungen, die nur leicht oberhalb der Schwellenspannung der Leistungsschalter LS1 und LS2 liegen, kann dies das Anschwingen verhindern. Durch die Vorwiderstände wird die Gatespannung der Leistungsschalter LS1 und LS2 beim Einschalten langsam auf die Eingangsspannung angehoben, so dass es zum sicheren Anschwingen kommen kann.

Bei der Wahl von Vorwiderständen kleiner als ca. 10 kΩ kann die Schaltung übergehen zu der bekannten Schaltung gemäß Fig. 1 b) mit Diodenkopplung und Pullup-Widerständen. Hierbei wird die parasitäre Bodydiode der SteuerMOSFETs SS1 und SS2 wirksam zum Entladen der Gatekapazität der Leistungsschalter LS1 und LS2. Bei der parasitären Bodydiode handelt es sich um eine im MOSFET parasitär vorhandene Diode, die einen DC-Stromfluss von Source nach Drain ermöglicht.

Die Schaltungskennlinie des Rückkopplungskreises wird bei der erfindungsgemäßen Steuerschaltung S (siehe Fig. 2 bzw. Fig. 3 bei Verwendung von Vorwiderständen größer als 10 kΩ) im Wesentlichen von der spannungsabhängigen nichtlinearen Kapazität der Schaltelemente bestimmt. Dadurch entstehen geringere Schaltverluste. Die Gates der Leistungsschalter LS1 und LS2 werden im erfindungsgemäßen Resonanzwandler über den Rückkoppelkreis aus der Ausgangsspannung versorgt, so dass der Gate-Ladestrom von der Induktivität des Oszillators zur Verfügung gestellt wird. Deswegen entstehen beim Laden- und Entladen geringe ohmsche Ladeverluste.

Beim Einsatz von realen Vorkapazitäten, deren Kapazität nicht auf 0 abfällt, beginnt das Entladen der Gatekapazitäten der Leistungsschalter LS1 und LS2 bereits nach dem Erreichen der maximalen Ausgangsspannung. Hierdurch kann es, beim Einsatz von Überspannungsschutzdioden, zu einem zu frühem Öffnen der Leistungsschalter LS1 und LS2 kommen. Dieser Effekt kann durch die Vorwiderstände R1 und R2 kompensiert werden. Zur weiteren Kompensation können die Kapazitäten C1 und C2 verwendet werden. Diese verringern zudem die Beeinflussung der GateSpannungen der LeistungsMOSFETs durch Verschiebeströme durch die Millerkapazitäten (parasitäre Drain-Gate-Kapazität).

Zur Dämpfung, Reduktion der Schaltzeit der LeistungsMOSFETs und zur Reduktion der Stromänderungsraten pro Zeit können zusätzlich Gate-Widerstände verwendet werden. Diese befinden sich wie auch die SteuerMOSFETs in der Reihenschaltung zwischen D1 von LS1 und G2 von LS2 bzw. zwischen D2 von LS2 und G1 von LS1. Zwei Mögliche Positionen sind in Fig. 4 dargestellt. Die Gate-Widerstände weisen typischerweise Werte kleiner 10Ω auf.

Gegenüber den im Stand der Technik aufgeführten üblichen Verfahren 1 und 2 für das Rückführungsnetzwerk steigt die Verstärkung im Rückkoppelzweig an, so dass ein einfacheres Anschwingen ermöglicht wird. Gerade beim Anschwingen, wenn nur kleine Ausgangsspannungen anliegen, ist die Kapazität der Steuerschalter SS1 und SS2 viel größer als die Gatekapazität der Leistungsschalter LS1 und LS2.

Durch die Kapazität der Steuerschalter SS1 und SS2 wird bereits vor dem Spannungsnulldurchgang damit begonnen, die Gates der Leistungsschalter LS1 und LS2 zu entladen. Dies ermöglicht es, sehr präzise im Spannungsnulldurchgang zu schalten.

Diese Schaltung ist selbstschwingend, so dass sie automatisch von sich aus anfängt zu schwingen. Das thermische Rauschen bzw. der Einschaltimpuls reicht aus, um den Oszillator zu starten.

Die Schaltung kommt ohne aktiv schaltende Elemente im Rückkoppelpfad aus und weist gegenüber aktiv geregelten Systemen eine weit reduzierte Schaltungskomplexität auf.

Die erfindungsgemäße Steuerschaltung S ist zur Verwendung in Leistungsoszillatoren insbesondere für Radiofrequenzgeneratoren geeignet. Ein Anwendungsgebiet dieser Generatoren ist das Heizen von Plasmen in Ionenquellen. Ein Vertreter dieser Ionenquellen ist z. B. ein Radiofrequenzionentriebwerk, eine Anordnung zum Beschichten/Sputtern sowie lonenextraktionsquellen für Fusionsanlagen. Des Weiteren kann die Schaltung auch für andere Aufgaben verwendet werden in denen ein Oszillator benötigt wird. Dies kann z. B. bei einer induktiven Energieübertragung, beim induktiven Heizen von Metallen, bei DC/DC-Wandlern oder bei weiteren Anwendungen der Fall sein. Ein Anpassen der Schaltung auf verschiedene Frequenz- und Leistungsbereich ist möglich.

### Abbildungslegenden und Bezugszeichenliste

**Fig. 1** zeigt den Stand der Technik
   a. mit Bipolartransistoren. Die Induktivitäten L2, L3, L4 und L5 sind magnetisch gekoppelt.
   b. mit MOSFETs, Diodenkopplung und Pullup-Widerständen. Die Induktivitäten L2 und L3 sind magnetisch gekoppelt.
**Fig.2** zeigt einen Schaltplan eines Leistungsoszillators mit einer erfindungsgemäßen Steuerschaltung S. Die Induktivitäten L2 und L3 sowie die Kapazität C3 bilden den Schwingkreis in den die Leistungsschalter LS1 und LS2 mit Hilfe der Induktivität L1 Leistung einspeisen. Mögliche Gate-Widerstände sind nicht eingezeichnet.
**Fig.3** zeigt einen Schaltplan eines Leistungsoszillators mit einer erfindungsgemäßen Steuerschaltung S mit optionalen Überspannungselementen ÜD1 exemplarisch dargestellt bestehend aus ÜD1a und ÜD1b sowie ÜD2 exemplarisch dargestellt bestehend aus ÜD2a und ÜD2b zur Spannungsbegrenzung der Gate-Spannungen, optionalen Vorwiderständen R1 und R2 sowie optionalen Kapazitäten C1 und C2, um das Spannungsteilerverhältnis anzupassen. Mögliche Gate-Widerstände sind nicht eingezeichnet.

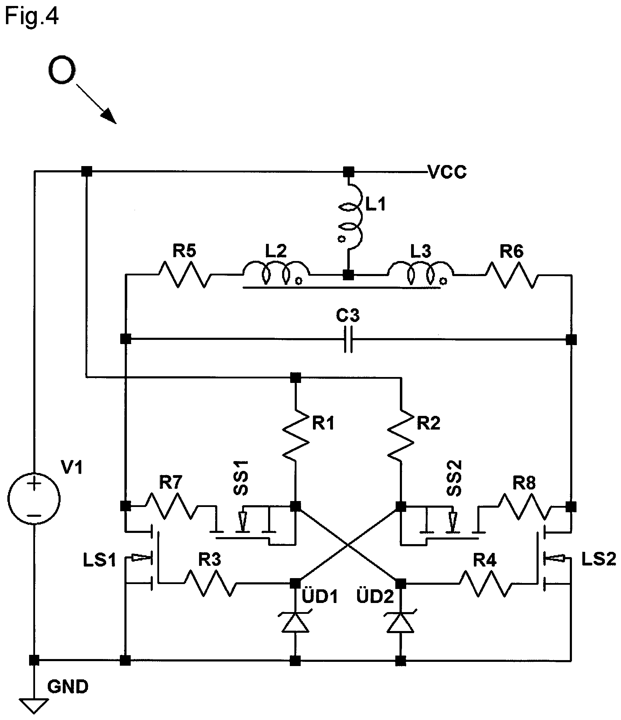

**Fig.4** dient als Auslegungsbeispiel für die erfindungsgemäße Steuerschaltung S, die in einer entsprechenden Oszillatorschaltung (O) verschaltet ist. Die Widerstände R5 und R6 in Reihe zur Oszillatorspule beschreiben die Belastung des Oszillators wie sie z.B. durch ein Plasma entstehen kann. Mögliche Werte sind 1 µH für L2 und L3, 40 µH für L1, jeweils 1 Ω für R5 und R6 sowie 5 nF für C3 ergebend eine Resonanzfrequenz von etwa 1,1 MHz. Als LeistungsMOSFETs LS1 und LS2 werden hier beispielsweise BSC600N25NS3 verwendet. Mögliche SteuerMOSFETs SS1 und SS2 sind sind n-Kanal, normal sperrende Leistungsmosfets auf Siliziumbasis. Die Widerstände R3, R4, R7 und R8 zeigen mögliche Positionen für Gate-Widerstände, um die Schaltzeiten bzw. die Stromänderungsraten pro Zeit zu reduzieren. Für ÜD1 und ÜD2 können Z-Dioden mit 12 V Sperrspannung eingesetzt werden.
**Fig.5** zeigt einen nichtlinearen Spannungsteiler
**Fig.6** zeigt mögliche Konfigurationen für die Anbringung der stromspeisenden Drossel bzw. der stromspeisenden Drosseln für den Schwingkreis.

### Bezugszeichenliste

- O: Oszillatorschaltung
- S: Steuerschaltung
- Q1 NPN, Q2 NPN: Schalter
- LS1, LS2: Leistungsschalter
- SS1, SS2: Steuerschalter
- ÜD1, ÜD2: Überspannungselement
- ÜD1a, ÜD1b: Bestandteil des Überspannungselements ÜD1
- ÜD2a, ÜD2b: Bestandteil des Überspannungselements ÜD2
- C1, C2: Parallelkapazität zur Gate-Source-Strecke
- C3: Resonanzkondensator des Schwingkreises
- L1, L6: Drosselinduktivität als Stromquelle
- L2, L3: Resonanzinduktivität des Schwingkreises
- L4: Rückkopplungswicklung (Hilfswicklung)
- L5: Ausgangswicklung
- R1, R2: Vorwiderstand
- R3, R4, R7, R8: Vorwiderstände bzw. Gate-Widerstände
- R5, R6: Lastwiderstände bzw. Plasmawiderstand
- S1, S2, S3, S4: Source
- G1, G2, G3, G4: Gate
- D1, D2, D3, D4: Drain
- V1: Versorgungsspannung
- V2: Hilfsspannung
- VCC: Potential der Versorgungsspannung
- GND: Potential der Masse bzw. 0 V

## Patentansprüche

1. Steuerschaltung (S) für parallelgespeiste Oszillatoren umfassend
• einen ersten Leistungsschalter (LS1) mit einer ersten Source (S1), einem ersten Gate (G1) und einem ersten Drain (D1)
• einen zweiten Leistungsschalter (LS2) mit einer zweiten Source (S2), einem zweiten Gate (G2) und einem zweiten Drain (D2)
• einen ersten Steuerschalter (SS1) mit einer dritten Source (S3), einem dritten Gate (G3) und einem dritten Drain (D3), wobei der erste Steuerschalter (SS1) als MOSFET ausgebildet ist
• einen zweiten Steuerschalter (SS2) mit einer vierten Source (S4), einem vierten Gate (G4) und einem vierten Drain (D4), wobei der zweite Steuerschalter (SS2) als MOSFET ausgebildet ist
**dadurch gekennzeichnet dass**, die erste Source (S1) und die zweite Source (S2) gemeinsam mit Masse (GND) verbunden sind, das erste Gate (G1) über eine Reihenschaltung bestehend aus mindestens dem zweiten Steuerschalter (SS2) mit dem zweiten Drain (D2) verbunden ist, wobei der zweite Steuerschalter (SS2) so angeordnet ist, dass das vierte Drain (D4) eine Verbindung zum zweiten Drain (D2) aufweist und die vierte Source (S4) eine Verbindung mit dem ersten Gate (G1) aufweist, wobei das zweite Gate (G2) über eine Reihenschaltung bestehend aus mindestens dem ersten Steuerschalter (SS1) mit dem ersten Drain (D1) verbunden ist, wobei der erste Steuerschalter (SS1) so angeordnet ist, dass das dritte Drain (D3) eine Verbindung zu dem ersten Drain (D1) aufweist und die dritte Source (S3) eine Verbindung mit dem zweiten Gate (G2) aufweist, wobei der erste Steuerschalter (SS1) eine Verbindung von dem dritten Gate (G3) zu der dritten Source (S3) und der zweite Steuerschalter (SS2) eine Verbindung von dem viertem Gate (G4) zu der vierten Source (S4) aufweist und die Steuerschaltung dazu ausgebildet ist, dass sich aus der jeweiligen Kapazität (Cv) des jeweiligen Steuerschalters und der zugehörigen Gatekapazität des ersten Leistungsschalters (LS1) und des zweiten Leistungsschalters (LS2) ein nicht linearerer kapazitiver Spannungsteiler ergibt, bei dem die Kapazität (Cv) des ersten Steuerschalters (SS1) und des zweiten Steuerschalters (SS2) wenigstens so groß ist, dass durch den ersten Steuerschalter (SS1) und den zweiten Steuerschalter (SS2) bei Betrieb mit der maximalen Ausgangsspannung eine so große Ladung verschoben wird, dass es durch diese Ladung am ersten Gate (G1) und am zweiten Gate (G2) zu einer Spannungsänderung, wenigstens in der Größe, die zum sicheren Durchschalten ausreichend ist, kommt.

2. Steuerschaltung (S) gemäß Anspruch 1 **dadurch gekennzeichnet, dass** diese weiterhin zwei Überspannungselemente (ÜD1) und (ÜD2) umfasst, welche so ausgebildet sind, dass ein erstes Überspannungselement (ÜD1) die Gatespannung des ersten Leistungsschalters (LS1) und ein zweites Überspannungselement (ÜD2) die Gate-spannung des zweiten Leistungsschalters (LS2) begrenzen kann.

3. Steuerschaltung (S) gemäß Anspruch 1 oder 2 **dadurch gekennzeichnet, dass** diese weiterhin zwei Vorwiderstände (R1) und (R2) umfasst, welche so ausgebildet sind, dass sich ein erster Vorwiderstand (R1) zwischen einer Versorgungsspannung und dem zweiten Gate (G2) und ein zweiter Vorwiderstand (R2) zwischen einer Versorgungsspannung und dem ersten Gate (G1) befinden.

4. Steuerschaltung (S) gemäß einem der Ansprüche 1 bis 3 **dadurch gekennzeichnet, dass** diese weiterhin zwei Kapazitäten (C1) und (C2) umfasst, welche so ausgebildet sind, dass sich eine erste Kapazität (C1) zwischen den Anschlüssen erstes Gate (G1) und erste Source (S1) und eine zweite Kapazität (C2) zwischen den Anschlüssen zweites Gate (G2) und zweite Source (S2) befindet.

5. Steuerschaltung (S) gemäß einem der Ansprüche 1 bis 4 **dadurch gekennzeichnet, dass** die Leistungsschalter (LS1) und (LS2) als spannungsgesteuerte Schalter ausgebildet sind.

6. Steuerschaltung (S) gemäß einem der vorigen Ansprüche **dadurch gekennzeichnet, dass** die Steuerschalter (SS1) und (SS2) als MOSFETs ausgeführt sind.

7. Oszillatorschaltung (O) **dadurch gekennzeichnet, dass** diese eine Steuerschaltung (S) gemäß einem der Ansprüche 1 bis 6 aufweist.

## Claims

1. A control circuit (S) for oscillators powered in parallel, comprising
• a first power switch (LS1) having a first source (S1), a first gate (G1) and a first drain (D1)
• a second power switch (LS2) having a second source (S2), a second gate (G2) and a second drain (D2)
• a first control switch (SS1) having a third source (S3), a third gate (G3) and a third drain (D3), wherein the first control switch (SS1) is configured as a MOSFET
• a second control switch (SS2) with a fourth source (S4), a fourth gate (G4) and a fourth drain (D4), wherein the second control switch (SS2) is configured as a MOSFET
**characterised in that** the first source (S1) and the second source (S2) are connected in common to earth (GND), the first gate (G1) is connected to the second drain (D2) via a series connection comprising at least the second control switch (SS2), wherein the second control switch (SS2) is arranged such that the fourth drain (D4) is connected to the second drain (D2) and the fourth source (S4) is connected to the first gate (G1), wherein the second gate (G2) is connected to the first drain (D1) via a series connection comprising at least the first control switch (SS1) to the first drain (D1), wherein the first control switch (SS1) is arranged such that the third drain (D3) is connected to the first drain (D1) and the third source (S3) is connected to the second gate (G2), wherein the first control switch (SS1) provides a connection from the third gate (G3) to the third source (S3) and the second control switch (SS2) provides a connection from the fourth gate (G4) to the fourth source (S4), and the control circuit is configured such that such that the respective capacitance (Cv) of each control switch, together with the associated gate capacitance of the first power switch (LS1) and the second power switch (LS2), results in a non-linear capacitive voltage divider, in which the capacitance (Cv) of the first control switch (SS1) and the second control switch (SS2) is at least large enough that, when operating at the maximum output voltage, a charge of sufficient magnitude is transferred through the first control switch (SS1) and the second control switch (SS2) to cause a voltage change at the first gate (G1) and the second gate (G2) that is at least of a magnitude sufficient to ensure safe conduction.

2. Control circuit (S) according to claim 1, **characterised in that** it further comprises two overvoltage elements (ÜD1) and (ÜD2), which are configured such that the overvoltage element (ÜD1) can limit the gate voltage of the power switch (LS1) and the overvoltage element (ÜD2) can limit the gate voltage of the power switch (LS2).

3. Control circuit (S) according to claim 1 or 2, **characterised in that** it further comprises two series resistors (R1) and (R2), which are configured such that the series resistor (R1) is connected between a supply voltage and the gate (G2) and the series resistor (R2) is connected between a supply voltage and the gate (G1).

4. Control circuit (S) according to one of claims 1 to 3, **characterised in that** it further comprises two capacitors (C1) and (C2), which are configured such that capacitor (C1) is located between the gate (G1) and source (S1) terminals and capacitor (C2) is located between the gate (G2) and source (S2) terminals.

5. Control circuit (S) according to any one of claims 1 to 4, **characterised in that** the power switches (LS1) and (LS2) are designed as voltage-controlled switches.

6. A control circuit (S) according to one of the preceding claims, **characterised in that** the control switches (SS1) and (SS2) are implemented as MOSFETs.

7. An oscillator circuit (O), **characterised in that** it comprises a control circuit (S) according to one of claims 1 to 6.

## Revendications

1. Circuit de commande (S) pour oscillateurs alimentés en parallèle, comprenant
• un premier commutateur de puissance (LS1) comportant une première source (S1), une première grille (G1) et un premier drain (D1)
• un deuxième commutateur de puissance (LS2) comportant une deuxième source (S2), une deuxième grille (G2) et un deuxième drain (D2)
• un premier commutateur de commande (SS1) comportant une troisième source (S3), une troisième grille (G3) et un troisième drain (D3), le premier commutateur de commande (SS1) étant réalisé sous la forme d'un MOSFET
• un deuxième commutateur de commande (SS2) comportant une quatrième source (S4), une quatrième grille (G4) et un quatrième drain (D4), le deuxième commutateur de commande (SS2) étant réalisé sous la forme d'un MOSFET
**caractérisé en ce que** la première source (S1) et la deuxième source (S2) sont reliées conjointement à la masse (GND), la première grille (G1) est reliée au deuxième drain (D2) via un montage en série composé au moins du deuxième commutateur de commande (SS2), le deuxième commutateur de commande (SS2) est agencé de telle sorte que le quatrième drain (D4) soit relié au deuxième drain (D2) et que la quatrième source (S4) soit reliée à la première grille (G1), la deuxième grille (G2) étant reliée au premier drain (D1) via un montage en série composé au moins du premier commutateur de commande (SS1) au premier drain (D1), le premier commutateur de commande (SS1) étant agencé de telle sorte que le troisième drain (D3) soit relié au premier drain (D1) et que la troisième source (S3) soit reliée à à la deuxième grille (G2), le premier commutateur de commande (SS1) établissant une connexion entre la troisième grille (G3) et la troisième source (S3) et le deuxième commutateur de commande (SS2) établissant une connexion entre la quatrième grille (G4) et la quatrième source (S4), et le circuit de commande étant conçu pour de manière à ce que la capacité respective (Cv) de chaque commutateur de commande et la capacité de grille correspondante du premier commutateur de puissance (LS1) et du deuxième commutateur de puissance (LS2) forment un diviseur de tension capacitif non linéaire, dans lequel la capacité (Cv) du premier commutateur de commande (SS1) et du deuxième commutateur de commande (SS2) est au moins suffisante pour que, lors du fonctionnement à la tension de sortie maximale, une charge suffisamment importante soit déplacée par le premier commutateur de commande (SS1) et le deuxième commutateur de commande (SS2), de sorte que cette charge provoque, au niveau de la première grille (G1) et de la deuxième grille (G2), une variation de tension d'une amplitude au moins suffisante pour assurer la conduction en toute sécurité.

2. Circuit de commande (S) selon la revendication 1, **caractérisé en ce qu'**il comprend en outre deux éléments de surtension (ÜD1) et (ÜD2), qui sont conçus de telle sorte que l'élément de protection contre les surtensions (ÜD1) puisse limiter la tension de grille du disjoncteur de puissance (LS1) et que l'élément de protection contre les surtensions (ÜD2) puisse limiter la tension de grille du disjoncteur de puissance (LS2).

3. Circuit de commande (S) selon la revendication 1 ou 2, **caractérisé en ce qu'**il comprend en outre deux résistances de série (R1) et (R2), qui sont conçues de telle sorte que la résistance de série (R1) soit intercalée entre une tension d'alimentation et la grille (G2) et la résistance de série (R2) entre une tension d'alimentation et la grille (G1).

4. Circuit de commande (S) selon l'une des revendications 1 à 3, **caractérisé en ce qu'**il comprend en outre deux capacités (C1) et (C2), qui sont agencées de telle sorte que la capacité (C1) se trouve entre les bornes grille (G1) et source (S1) et que la capacité (C2) se trouve entre les bornes grille (G2) et source (S2).

5. Circuit de commande (S) selon l'une des revendications 1 à 4, **caractérisé en ce que** les interrupteurs de puissance (LS1) et (LS2) sont réalisés sous forme d'interrupteurs commandés en tension.

6. Circuit de commande (S) selon l'une des revendications précédentes, **caractérisé en ce que** les commutateurs de commande (SS1) et (SS2) sont réalisés sous forme de MOSFET.

7. Circuit oscillateur (O) **caractérisé en ce qu'**il comprend un circuit de commande (S) selon l'une des revendications 1 à 6.
